(19) Europäisches Patentamt / European Patent Office / Office européen des brevets

(11) **EP 3 483 700 B1**

(12) **EUROPEAN PATENT SPECIFICATION**

(45) Date of publication and mention
of the grant of the patent:
**06.01.2021 Bulletin 2021/01**

(51) Int Cl.:
*G06F 1/26* $^{(2006.01)}$     *G11C 5/00* $^{(2006.01)}$
*H04L 12/10* $^{(2006.01)}$

(21) Application number: **18204694.6**

(22) Date of filing: **06.11.2018**

(54) **METHOD AND DEVICE FOR GENERATING A VOLTAGE DROP PULSE**

VERFAHREN UND VORRICHTUNG ZUR ERZEUGUNG EINES SPANNUNGSABFALLIMPULSES

PROCÉDÉ ET DISPOSITIF POUR GÉNÉRER UNE IMPULSION DE CHUTE DE TENSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.11.2017 GB 201718484**

(43) Date of publication of application:
**15.05.2019 Bulletin 2019/20**

(73) Proprietor: **CANON KABUSHIKI KAISHA
Ohta-ku
Tokyo 146-8501 (JP)**

(72) Inventors:
• **MERLET, Hervé
35530 SERVON SUR VILAINE (FR)**
• **LAGRANGE, Pascal
35520 LA CHAPELLE DES FOUGERETZ (FR)**

(74) Representative: **Santarelli
49, avenue des Champs-Elysées
75008 Paris (FR)**

(56) References cited:
**WO-A1-2008/135774**    **US-A1- 2008 052 546**
**US-A1- 2010 141 282**

EP 3 483 700 B1

**Description**

FIELD OF THE INVENTION

The present invention relates to a method of generating a voltage drop pulse, in particular a device that is part of a network such as a video surveillance network during network topology determination.

BACKGROUND OF THE INVENTION

A typical digital video surveillance system comprises a plurality of digital cameras and at least two types of wire networks - a first type of wire network for data transport to and from the cameras, and a second type of wire network for power distribution to the cameras.

It may be useful, for example to save costs, to use a single wire infrastructure to distribute both data and power from a central point to a plurality of cameras. Technology allowing both data and power to be carried over a single wire exists, known by various names such as "Power over Ethernet", "PoE", "Power over Coax", "PoC", "Ethernet over Coax" or "EoC". An existing analog camera surveillance infrastructure using such technology may be advantageously upgraded to a digital video surveillance system by reusing existing wires able to support power distribution (e.g. coaxial cables), adding a "central adapter" to the central point, replacing existing analog cameras with digital cameras, adding extension cables and digital cameras as needed, and adding "terminal adapters" to the cameras. The publication US2008052546 A1 discloses an inline power policing method for providing electrical power, which involves continuing to provide power to powered devices if power budget is not exceeded, and initiating action at power sourcing equipment, if power budget is exceeded.

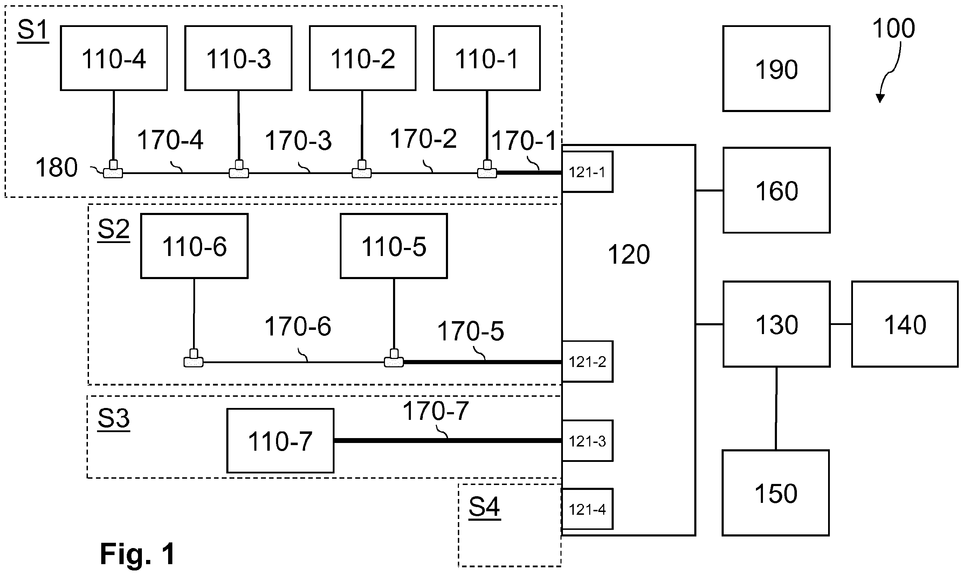

**Figure 1** shows a communication system 100 comprising a plurality of devices 110-m, m being an index from 1 to M (M=7 in the illustrated example). In particular, the system 100 is a retrofitted video surveillance network, that is to say, an analog video surveillance network that has been upgraded to IP (Internet Protocol) video, and the devices 110-m are here IP cameras. The network 100 further comprises a central point or "power source equipment" PSE 120 (also known as an "Ethernet over Coax receiver", "EoC receiver", "Head-end adapter", or "IP over Coax receiver"), a Local Area Network or LAN 130, a video monitoring system 140, a digital video recorder 150, a power supply 160, cables 170-m, T-style connectors 180, and an installation tool 190.

The cameras 110-m are linked to ports 121-n (n being an index from 1 to N, here N=4 in the illustrated example) of the PSE 120 by cables 170-m (m being the same index as the index of the corresponding camera). Cables and associated cameras connected to one port 121-n define a segment Sn of the network. In the illustrated example, the cameras 110-m are arranged in four segments S1, S2, S3, S4. Segment S1 comprises four cameras 110-1, 110-2, 110-3, 110-4, segment S2 comprises two cameras 110-5, 110-6, segment S3 comprises one camera 110-7, and segment S4 comprises no cameras. Furthermore, the cameras 110-m may be either directly connected to a cable (as shown by camera 110-7), or by means of connectors 180 (as shown by the other cameras) used to increase the number of cameras connected to a main cable.

In this configuration example, cables 170-1, 170-5, 170-7 were already present in the previous network to transport analogue video signals. New digital cameras 110-1, 110-5, 110-7 replace the previous analogue cameras and additional cameras 110-2, 110-3, 110-4, 110-6 have been added, each coupled to an extension cable 170-2, 170-3, 170-4, 170-6. The cables 170-m can be as long as 300 meters and may be coaxial cables or any type of cable capable of transporting video signals.

The PSE 120 provides power over the cables 170-m, and thus to the cameras 110-m connected thereto. The adapter in the PSE 120 encapsulates uplink IP LAN traffic received from the LAN 130 into packets suitable for digital data transport on the cables as "IP Coax Traffic", and extracts IP LAN traffic from packets received on cables 170-m and forwards them on the LAN 130 as "Ethernet Traffic".

The LAN 130 includes the necessary switches, routers, and gateways that are necessary to transport the IP video to the video monitoring system 140 and to the recorder 150. The video monitoring system 140 is configured to display the IP video streams for surveillance purposes and may display power diagnosis information from the different cameras when the information is included in the IP video stream sent by the camera, this information being considered as part of "On Screen Display" or OSD data. The recorder 150 is configured to record the IP video stream, for example for play back at a later time.

The installation tool 190 is used to configure the cameras 110-m. The installation tool 190 may be either a mobile or hand-held device for configuring the cameras 'in-situ", that is to say, after they have been installed in the system.

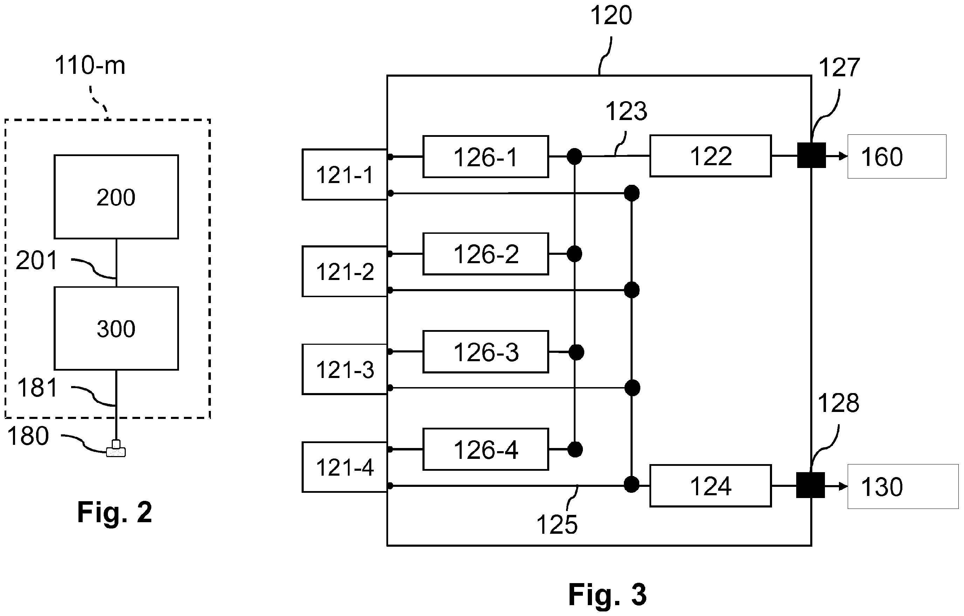

**Figure 2** schematically shows a device 110-m in further detail, according to one embodiment.

The device 110-m comprises a core camera module 200 (for example a model Dome PTZ VB-M50B from Canon (registered trademark RTM)) and a Coax terminal adapter 300 coupled by a wire 201 (such as an Ethernet cable). The terminal adapter 300 is coupled to a connector 180 by means of a cable 181 (or else directly connected to the cable, in the case of device 110-7). In the following, the core camera module 200 may be referred to simply as the camera module.

The terminal adapter 300 is connected to an Ethernet port of the camera module 200. The terminal adapter 300 converts IP Coax traffic arriving on the cable 170-m to Ethernet traffic and transfers it to the camera module 200, converts Ethernet traffic arriving from the camera module 200 to IP Coax Traffic and sends it on the cable, and receives power from the cable and supplies it to the camera module through the Ethernet port.

The terminal adapter 300 comprises a power management module configured to manage the power distribution to the camera module, in particular according to standards for power transport over Ethernet known as PoE (IEEE802.3af) or PoE+ (IEEE802.3at). In order to limit current consumption over the cable, the device 110-m should operate within a bounded input voltage range. For example, if the camera module is compliant with the Standards PoE (IEEE802.3af) or PoE+ (IEEE802.3at), the terminal adapter 300 should turn off the camera module when the input voltage of the camera module is below a minimum operating voltage, defined as 30 V by the PoE Standard.

Power distribution over data cables suffers from limitations on the total power that can be carried, and from a high power loss in the cables due to the relatively low voltage carried (e.g. a low voltage being comprised between 48 to 56 V).

**Figure 3** shows the power source equipment PSE 120 configured to be implemented in the network 100. The PSE 120 comprises the ports 121-n. Though only four ports are shown here, the PSE 120 may have 8, 16 or any other number of ports. The PSE 120 further comprises a main power supply 122, an internal power network 123, a network controller 124, an internal communication network 125, port protection circuits 126-n (n being the same index as of the ports), a power connection 127, and a data connection 128.

The main power supply 122 (here integrated within the body of the PSE 120, but not necessarily) is coupled to a power supply (e.g. reference 160 of **Figure 1**) by means of the power connection 127, and supplies a voltage-stabilized power supply to the ports 121-n by means of the internal power network 123. The main power supply 122 comprises a capacitor and a voltage regulator (not shown) forming a low-pass filter that filters any voltage drop pulses originating from ports 121-n. Consequently, a physical parameter variation, such as a voltage drop pulse, occurring on one segment Sn is filtered and is not propagated to other segments of the network.

Each port 121-n is current-limited by its corresponding protection circuit 126-n. Each protection circuit 126-n comprises a resistor and limits the distributed power to prevent destruction of the electronic components of the port and the cables connected thereto due to short circuits.

As an example, the main power supply 122 supplies a voltage-stabilized power supply of 56 V (volts) on the internal power network 123, and the protection circuits 126-n limit the power at each port 121-n to 50 W (watts). When the current at a port 121-n exceeds the authorized current, the corresponding protection circuit 126-n cuts the power on the considered port, shutting down the power supply to all cameras coupled thereto.

Each port 121-n of the PSE 120 is coupled to the network controller 124 by means of the internal communication network 125. The controller 124 is coupled to the data connection 128, which is in turn adapted to connect to the LAN 130 of **Figure 1.** The controller 124 is configured to encapsulate uplink IP LAN traffic received from the LAN into packets suitable for digital data transport on cables according to given protocol such as the Home-Plug AV protocol or the HD-PLC protocol, and to transmit them on the internal communication network 125. The controller 124 is also configured to extract IP LAN traffic from packets received on the internal communication network 125 and to forward them to the LAN. The devices 110-m of **Figure 1** share the same internal communication network 125 and can therefore communicate with each other. From a data communication point of view, the devices 110-m virtually belong to a single network segment, that is to say, data sent from a device on one segment, such as segment S1, can be received by the devices of the other segments, such as segments S2 or S3.

As the topology of the power network is unknown, that is to say, how many and which devices are coupled to each port 121-n, it is difficult to know in advance the total power consumption that will be drawn on the port so as to prevent a power failure at the network start-up or during a hot-plug of one or several devices (that is to say, adding one or more devices while the system is operating). The total power consumption on one segment or one port is the power dissipated in the cable due to the resistivity of the cable (Joule effect), and the power consumption of each device.

The power supply is constrained at two levels - the port level and the system level. The power is constrained at the port level because the PSE 120 is only able to deliver or supply power to a port up to a fixed maximum amount of power, independent of the number of devices 110-m connected to a port 121 -n. The power is also constrained at the system level because the power available per port is maintained and limited by the capacity provided by the PSE 120. Typically, the PSE 120 has an overall power capacity that is less than the sum of port power capacities of individual switch ports.

The PSE 120 is protected against power overrun. The ports have software protection that cuts the power supply when a power overrun is detected at the port level or at the system level, and restores the power supply when the power demand is acceptable again.

Moreover, each of the ports 121-n may be provided with a fuse protection in case the software protection fails. The PSE 120 itself is also protected by software and/or hardware such as a fuse. However, in IP over Coax systems (and more generally in PoC systems), a power overrun may result in the shutdown of a port, a system shut down, or more seriously, a blown fuse either at the port level or at the system level.

Power overrun may also lead to significant voltage drop at the level of the terminal adapter 300. If the voltage at the terminal adapter 300 falls below a minimum operating voltage, the camera module 200 may shut down, severely impacting the quality of service of the system 100. In particular, the camera module 200 becomes non-functional, i.e. its main functions are stopped, such as streaming video.

SUMMARY OF THE INVENTION

The present invention has been devised to address at least one of the foregoing concerns, in particular to prevent non-functionality of a device.

Embodiments of the invention thus relate to a method of determining a magnitude of a voltage drop pulse in a network comprising at least two devices on a voltage supply line, the method comprising :

measuring typical operating voltages of the at least two devices in stable operating phases;
determining which of the at least two devices has the lowest typical operating voltage as the determined device;
determining a minimum operating voltage of at least the determined device, below which the determined device will be non-functional; and
determining, from the lowest typical operating voltage, the magnitude of the voltage drop pulse that will not cause the voltage of the determined device to go below the minimum operating voltage.

According to one embodiment, the determined magnitude is approximately equal to a maximum voltage range defined as the difference between the typical voltage of the determined device and the minimum operating voltage.

According to one embodiment, a security margin is taken into consideration when calculating the determined magnitude.

According to one embodiment, the at least two devices are considered to have the same minimum operating voltage.

Embodiments of the invention also relate to a method of generating a voltage pulse in a network comprising at least two devices on a voltage supply line, the method comprising the steps of:

determining the magnitude of the voltage drop pulse according to an embodiment of the invention; and
generating the voltage drop pulse with the determined magnitude, by the determined device.

According to one embodiment, the method comprises the steps of:

sending a pulse generation notification by the determined device to a non-generating device or devices before generating the voltage drop pulse; and
receiving the pulse generation notification by the non-generating device or devices; and
measuring by the non-generating device or devices the voltage at their inputs in order to detect or not the generated voltage drop pulse.

According to one embodiment, the method comprises a step of measuring by the non-generating device or devices the voltage at their inputs in order to detect or not the generated voltage drop pulse.

According to one embodiment, the method comprises a step of sending a pulse detection result by the non-generating device or devices indicating whether it detected or not the generated voltage drop pulse.

According to one embodiment, the method comprises the steps of:

determining whether all devices detected a voltage drop pulse;
if the response is no, then determining whether all the devices have generated a voltage drop pulse; and
if the response is no, then generating a voltage drop pulse by another device.

Embodiments of the invention also relate to a method of determining a network topology, the network comprising at least two devices on a voltage supply line, the method comprising the steps of
generating the voltage drop pulse with the determined magnitude by the determined device according to one embodiment of the invention;
detecting for the voltage drop pulse by the non-generating device or devices;,
receiving pulse detection results from the non-generating device or devices; and
determining the network topology based on the pulse detection results.

Embodiments of the invention also relate to a device to determine the magnitude of a voltage drop pulse in a network comprising at least two devices on a same voltage supply line, the device being configured to:

obtain typical operating voltages measured by the at least two devices in stable operating phases;
determine which of the at least two devices has the lowest typical operating voltage as the determined device;
determine a minimum operating voltage of at least the determined device, below which the determined device will be non-functional; and
determine, from the lowest typical operating voltage, the magnitude of the voltage drop pulse that will not cause the voltage of the determined device to go below the minimum operating voltage.

According to one embodiment, the determined magnitude is approximately equal to a maximum voltage range defined as the difference between the typical voltage of the determined device and the minimum operating voltage.

According to one embodiment, a security margin is taken into consideration when calculating the determined magnitude.

According to one embodiment, the at least two devices are considered to have the same minimum operating voltage.

Embodiments of the invention also relate to a device configured to generate a voltage pulse in a network comprising at least one other device on a same voltage supply line, the device being configured to:

determine the magnitude of the voltage drop pulse according to one embodiment of the invention; and
generate the voltage drop pulse with the determined magnitude.

According to one embodiment, the device is configured to:

send and receive a pulse generation notifications before a voltage drop pulse is generated; and
measure the voltage at its inputs in order to detect or not a generated voltage drop pulse.

According to one embodiment, the device is configured to measure the voltage at its inputs in order to detect or not a generated voltage drop pulse.

According to one embodiment, the device is configured to send a pulse detection result indicating whether it detected or not the generated voltage drop pulse.

Embodiments of the invention also relate to a master device for determining the topology of a network comprising at least two devices on a same voltage supply line,

wherein at least one device is configured to generate a voltage drop pulse;

at least another device is configured to detect the voltage drop pulse;

the master device being configured to receive pulse detection results, and to determine the network topology based on the pulse detection results

BRIEF DESCRIPTION OF THE DRAWINGS

Other particularities and advantages of the invention will also emerge from the following description, illustrated by the accompanying drawings, in which:

- **Figure 1**, previously described, shows a communication system comprising a plurality of devices and a central point,
- **Figure 2**, previously described, shows a device of Figure 1 in further detail,
- **Figure 3**, previously described, shows a central point of the system of Figure 1 in further detail,
- **Figures 4A, 4B** schematically show terminal adapters to be used with devices according to embodiments,
- **Figure 5** illustrates in further detail a portion of the terminal adapter of Figures 4, according to an embodiment,
- **Figures 6A, 6B** are graphs of voltage over time of voltages across a device according to embodiments,
- **Figure 7** is a flowchart of a method of determining a magnitude of a voltage drop pulse to be generated, according to an embodiment,
- **Figure 8** is a circuit diagram of a means for generating a voltage drop pulse, according to one embodiment,
- **Figure 9** illustrates a group of messages that may be exchanged within a device, according to an embodiment,
- **Figure 10** is a flowchart of a method of determining network topology by generation of a voltage drop pulse, according to an embodiment,
- **Figure 11** illustrates a group of messages that may be exchanged amongst devices, according to an embodiment, and
- **Figure 12** is a protocol transaction chart for the exchanges of messages amongst the devices, according to an embodiment.

DETAILED DESCRIPTION OF EMBODIMENTS OF THE INVENTION

Embodiments of the invention relate in general to a method of preventing device shutdown, in particular a device that is part of a network such as a video surveillance network during network topology determination.

For the sake of illustration, embodiments of the invention are presented in the context of a Power over Cable (specifically, coaxial cables) video surveillance network. Nevertheless, other embodiments of the invention may be envisaged outside this context such as a non-video surveillance network and/or a non-Power over Cable network, e.g. dual power and data networks not sharing the same cables (e.g. cable power network and wireless communication network).

Furthermore, embodiments of the invention are illustrated with a camera device comprising a camera module compliant with PoE or PoE+ standard. Nevertheless, other embodiments may be envisaged such as a camera device that is natively adapted to connect to the wire network, i.e. the camera module does not necessarily implement an Ethernet port and the network traffic (e.g. IP Coax traffic) may processed by the device without being converted to Ethernet traffic.

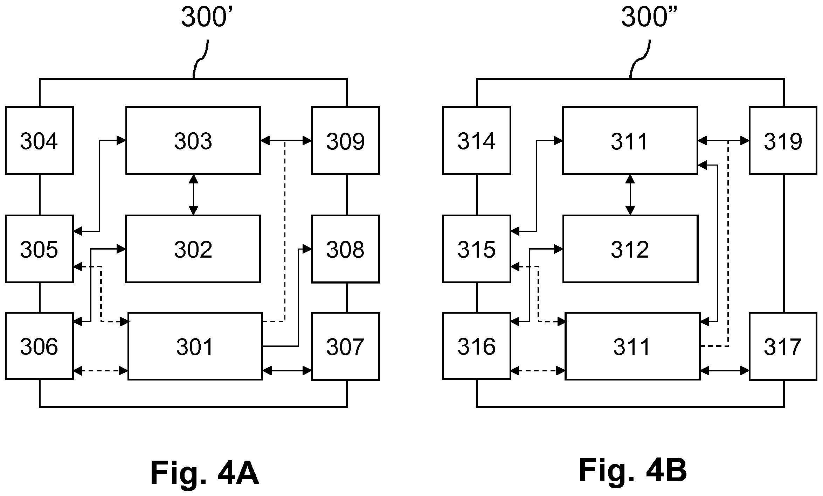

**Figures 4A, 4B** schematically show terminal adapters 300', 300" according to embodiments of the invention

**Figure 4A** schematically shows a terminal adapter 300' according to one embodiment of the invention, wherein the terminal adapter 300' and the camera module 200 (not shown in **Figure 4A**) are distinct items.

The terminal adapter 300' is connected to the camera module 200 by means of an Ethernet communication link and is configured to implement functions of Ethernet transport over coaxial cable and power management. The terminal adapter 300' is configured to implement power sensing, estimation of a voltage drop, and correction of an estimated voltage drop. The terminal adapter 300' is configured to communicate with the PSE 120 and to negotiate the power supplied by the PSE 120 to the camera module 200. Thus, the terminal adapter 300' comprises means for determining the power class of the camera module 200, that is to say its power consumption.

The terminal adapter 300' comprises a power manager 301, a HomePlug AV bridge 302, a 3-port Ethernet bridge 303, a push button 304, a configuration port 305, a BNC (Bayonet Neill-Concelman) connector 306, a signaling device 307, a serial connector 308, and a connection port 309. In the figure, the power supply is represented by dashed lines and the data connections are represented by solid lines.

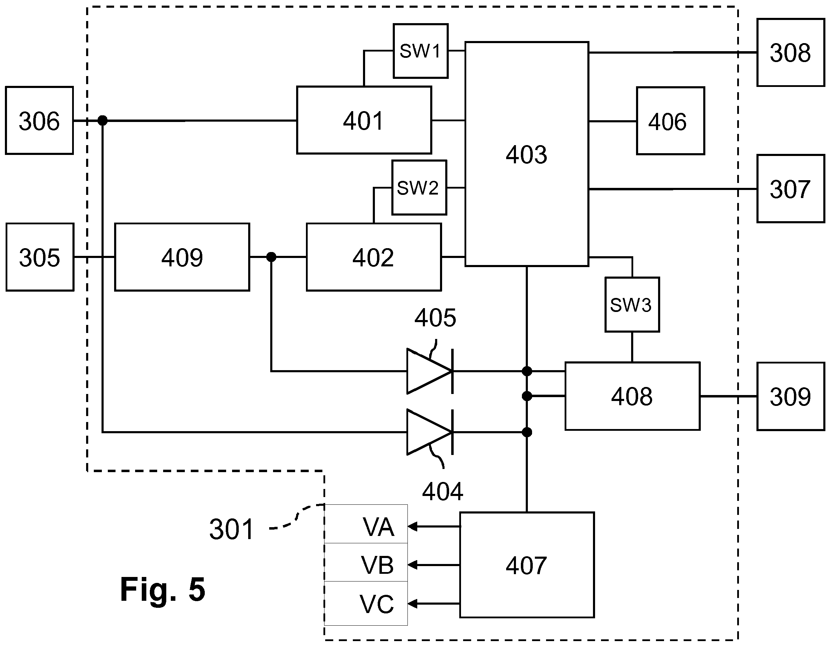

The power manager 301, also called a power management module, is configured to manage the power distribution to the camera module 200. The power manager 301 receives power from the BNC connector 306 and/or from the configuration port 305, and distributes the power to the camera module 200, to the HomePlug AV bridge 302, and to the Ethernet bridge 303. The power manager 301 distributes the power according to PoE (Power over Ethernet) standards. The power manager 301 will be described in further detail in relation with **Figure 5.**

The HomePlug AV bridge 302 is configured to encapsulate the IP camera traffic into HomePlug AV packets and to send them on the coaxial cable through the BNC connector 306. The HomePlug AV Bridge 302 is also configured to extract IP traffic from the received HomePlug AV packets and to forward this extracted IP traffic to the camera module 200.

The Ethernet bridge 303 is configured to mix IP traffic from the configuration port 305, the HomePlug AV bridge 302, and the connection port 309 (that is to say, from the camera module 200).

The push button 304 is for resetting the terminal adapter 300'. The configuration port 305 is used for camera setup purposes. The BNC connector 306 is used for IP traffic over a coaxial cable. The signaling device 307 may be for example LED ("Light Emitting Diodes") for displaying power diagnosis results. The serial connector 308 may be coupled to the power manager 301 means of a serial line, and may be used for sending data such as power diagnosis information to an external device connected to the terminal adapter 300' by means of the serial connector 308. The connection port 309, which may be an "RJ45 type port", is coupled to the camera module 200.

The installation tool 190 may be connected to the serial connector 308, and receive power information thereby, as well as other available parameters, such as a voltage margin, pulse timing, pulse detection results, the software version, and so forth.

As previously indicated, in this embodiment, the terminal adapter 300' and the camera module 200 are two distinct items. However, according to another embodiment that will now be described, the terminal adapter may be embedded in the camera module.

**Figure 4B** schematically shows a terminal adapter 300" according to one embodiment of the invention, wherein the terminal adapter 300" is embedded in the camera module 200.

The terminal adapter 300" is similar to the terminal adapter 300', and comprises a power manager 311, a HomePlug AV bridge 312, a 4-port Ethernet bridge 313, a push button 314, a configuration port 315, a BNC (Bayonet Neill-Concelman) connector 316, a signaling device 317, and an Ethernet connection port 319. Thus, unlike the terminal adapter 300', the terminal adapter 300" does not comprise a serial connector (308). As previously, the power supply is represented by dashed lines and the data connections are represented by solid lines in the figure.

The arrangement and functions of the elements of the terminal adapter 300" with respect to those of the terminal adapter 300' may be considered as essentially the same, with the exception that the three-port Ethernet Bridge 303 is replaced by a four-port Ethernet bridge 313, and the power manager 311 communicates via the Ethernet connection port 319 with either the camera module 200 or with the PSE 120, such that a serial connector (308) is not necessary.

**Figure 5** illustrates in further detail the power manager 301, according to one embodiment. In particular, the power manager 301 is used in a terminal adapter 300' according to the embodiment shown in relation with **Figure 4A.**

The power management module 301 comprises a first sensor 401, a second sensor 402, a microprocessor 403, a first diode 404, a second diode 405, a memory 406, a DC to DC converter 407, a power sourcing equipment 408, and a front end circuit 409.

The first sensor 401 is coupled to the microprocessor 403 via a switch SW1, and the second sensor 402 is coupled to the microprocessor 403 via a switch SW2. It may be noted that the sensors 401, 402 may be power sensors, voltage sensors, and/or current sensors, but for the sake of simplicity will be referred to as power sensors in the following.

The microprocessor 403 is configured to control and direct the execution of the instructions or portions of software code of the program or programs according to embodiments of the method for managing power, the instructions for which are stored in the memory 406, such as an NVRAM (non-volatile Random Access Memory).

The power is supplied by the ports 305 and/or 306 and is supplied to the camera module 200 by means of the power sourcing equipment 408 (here a PoE PSE or "Power over Ethernet Power Sourcing Equipment") under the control of the microprocessor 403. The power sourcing equipment 408 comprises a connection interface suitable for connecting the power management module 301 to the camera module 200, and is coupled to the microprocessor 403 by means of a third switch SW3, and is controlled thereby.

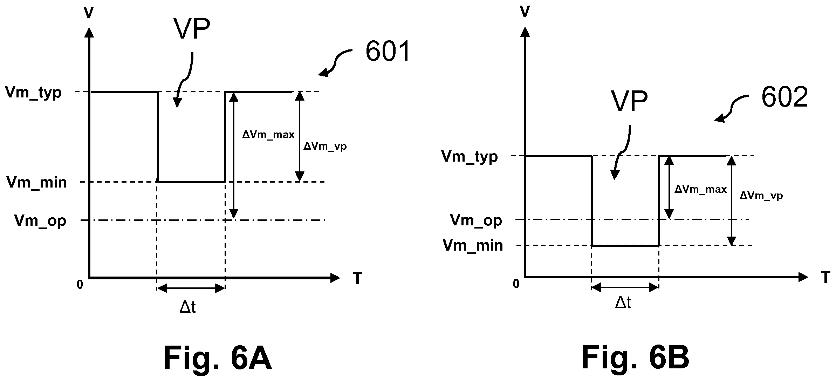

In particular, the power supplied via the BNC port 306 passes through the first sensor 401 and the first diode 404. The first sensor 401 supplies signals (described with reference to **Figures 6A, 6B**) used by the processor 403 to estimate the power that the power management module 301 is able to supply to the camera module 200 and to determine the available power delivered on the cable 170-m by the PSE 120.

The diodes 404, 405 respectively combine the power supplied via the configuration port 305 and the BNC connector 306. The combined power is supplied to both the converter 407 and the PoE PSE circuit 408.

The DC-DC converter 407 converts the input voltage into a voltage required by the terminal adapter 300' to function. The voltages on the cables 170-m may be for example 56 V, whereas the voltages required for the operation of the terminal adapter 300' may be for example 1.05 V (VA), 1.3 V (VB), and 11 V (VC).

The power supplied via the configuration port 305 is supplied through the front end circuit 409, which may be a PoE PD ("Powered Device"), then through the second sensor 402 and the second diode 405. The second sensor 402 is used by the processor 403 to estimate the power the power management module 301 can supply to the camera module 200 and to determine the available power delivered on the Ethernet cable 201 coupling the terminal adapter 300' and the camera module 200.

Thus, the power management module 301 comprises means for estimating a power that may be supplied via the connection interface.

The camera module 200 is powered by means of the power sent through the port 309. The port 309 receives power from the circuit 408 via the connector 306 and the first diode 404, and via the port 307 and the second diode 405, as previously indicated.

The microprocessor 403 supplies power diagnosis information to the camera module 200 by serial communication. In particular, the microprocessor 403 is coupled to the serial connector 308 of **Figure 4A.** The microprocessor 403 further controls the signaling means 307 for power diagnosis feedback. The signaling means 307 may simply comprise one or more Light Emitting Diodes (LED) of one or more different colors, for example a red color indicating that there is insufficient power, an orange color indicating that the power is close to the minimum power limit, and a green color indicating that the voltage and power are at sufficient levels.

The memory 406 is used by the microprocessor 403 to store and retrieve configuration parameters and parameters used when implementing power management methods according to embodiments of the invention.

In another embodiment, the power manager 311, described in relation with **Figure 4B,** is part of the core camera module 200. In this case, the microprocessor 403 is coupled to the Ethernet connection port 319 of **Figure 4B.**

**Figures 6A, 6B** respectively illustrate graphs 601, 602 of voltage V over time T of voltage variations across a device 110-m during the generation of a voltage drop pulse in two different scenarios.

With respect to the graphs 601, 602, a typical operating voltage Vm_typ may be defined as the voltage of a given device m in a stable phase without pulse generation or load. A minimum voltage Vm_min may be defined as the lowest voltage across the given device m during the voltage drop pulse. A voltage Vm_op may be defined as the minimum operating voltage below which the given device m is non-functional (e.g. the camera module 200 is powered down, shut off or in standby mode). It may be noted that by "non-functional", it is meant that the main function(s) of a device is(are) not provided. For example, the core camera module is shut down or in an inactive state and video streaming is no longer provided. However, the adapter may still be functional as it typically has a lower voltage operating level than the camera module (for example 1.05 V, 1.3 V, or 11 V as provided respectively by VA, VB and VC of **Figure 5**). The lower voltage operating level allows the adapter to manage the powering of the camera module 200 even though there is not enough power for powering the camera module. Still, if the voltage drops too low, the adapter may be powered down too.

A maximum voltage range $\Delta Vm\_max$ may be defined as the difference between the typical voltage $Vm\_typ$ and the minimum operating voltage $Vm\_op$ at a given device, that is $\Delta Vm\_max = Vm\_typ - Vm\_op$. A voltage drop pulse magnitude $\Delta Vm\_vp$ at the given device, related to the voltage drop pulse VP generated by another device, may be defined as the difference between the typical voltage $Vm\_typ$ and the minimum voltage $Vm\_min$, that is $\Delta Vm\_vp = Vm\_typ - Vm\_min$. The maximum voltage range $\Delta Vm\_max$ may be greater than, equal to, or less than the voltage drop pulse amplitude $\Delta Vm\_vp$.

It may be assumed that all devices 110-m have approximately the same minimum operating voltage $Vm\_op$, in particular if they are of the same type and of the same model. In any case, the minimum operating voltage $Vm\_op$ of each device should be known from installation, and may be stored and used in calculations if necessary.

Furthermore, as previously indicated, due to cable resistances, the typical voltage $Vm\_typ$ across a device 110-m is a function of the distance of the device 110-m from the PSE 120. It may be assumed that in the case of several cable segments, that each have the same electrical properties.

With reference to **Figure 1**, considering the devices of segment S1 as an example, it may be deduced that a voltage V4_typ (voltage across the device 110-4) is lower than the voltage V3_typ (voltage across the device 110-3), which is lower than the voltage V2_typ (voltage across the device 110-2), which is lower than the voltage V1_typ (voltage across the device 110-1). Consequently, $V4\_typ < V3\_typ < V2\_typ < V1\_typ$. The voltage $Vm\_typ$ across a device 110-m is stable until another device on the same segment generates a voltage drop pulse VP with a duration $\Delta t$.

If device 110-1 generates a voltage drop pulse VP, graph 601 of **Figure 6A** shows for example the voltages present at the next (closest) device 110-2, while the graph 602 of **Figure 6B** shows for example the voltages present at the last (farthest) device 110-4. In this case, it may be noted that the voltage $Vm\_typ$ of graph 601 is higher than the voltage $Vm\_typ$ of graph 602, while both have the same minimum operating voltage $Vm\_op$.

Upon generation of voltage drop pulse VP by another device (referred to as a generating device, for example device 110-1), the voltage across another device 110-m drops to a minimum $Vm\_min$.

If the voltage pulse amplitude $\Delta Vm\_vp$ is such that the minimum voltage $Vm\_min$ is less than the minimum operating voltage $Vm\_op$ of the device 110-m, as shown in **Figure 6B**, then the device switches into a non-functional state in which the main activities (functions) of the device are stopped, including the streaming of video, which may be unacceptable in a video surveillance system. That is to say, the magnitude $\Delta Vm\_vp$ of the voltage drop pulse should be chosen so that the minimum voltage $Vm\_min$ is higher than the minimum operating voltage $Vm\_op$, as shown in **Figure 6A**, otherwise the device will be non-functional. It may further be considered that the voltage pulse amplitude $\Delta Vm\_vp$ should be equal to or preferably lower than the maximum voltage range $\Delta Vm\_max$. To this end, the magnitude $\Delta Vm\_vp$ of the voltage drop pulse should be constrained so that the voltage of the most critical device does not drop below its minimum operating voltage.

It may be noted that considering the voltage attenuation in the cable segment, the current drawn by the generating device to generate the voltage drop pulse should be such that the voltage pulse amplitude $\Delta Vm\_vp$ at a given device is equal to or less than the maximum voltage range $\Delta Vm\_max$ at that given device. However, as an approximation, the generating device may take the magnitude $\Delta Vm\_vp$ of the device with the lowest typical voltage as the basis for determining the current to be drawn. This simplifies determining the voltage drop pulse while keeping the pulse magnitude lower than the maximum voltage range $\Delta Vm\_max$ for every device in the segment. Also, the generation of a voltage pulse with the same maximum voltage range by any of the devices should not cause any other device to be non-functional.

A security margin, for example of 5 to 10 percent may be considered when determining the magnitude, in order to compensate for any estimation/calculation errors, fluctuations in power, and so forth, so as to not accidently drop below the minimum operating voltage.

A voltage pulse amplitude $\Delta Vm\_vp$ acceptable for one device, for example device 110-2 as shown in graph 601, may be unacceptable for one or more other devices, for example device 110-4 as shown in graph 602. Thus, as noted above, if a generating device 110-m (for example device 110-1) generates a voltage drop pulse VP that is too strong, that is to say, has a high amplitude, then a device having a lower voltage (such as device 110-2, 110-3 and/or device 110-4) may become non-functional (e.g. inactive, or even be powered down), due to dropping below its minimum operating voltage $Vm\_op$.

The generating device determines the current I that needs to be drawn in order to generate a voltage drop pulse with a desired magnitude in the network segment. The higher the current, the higher the amplitude of the drop pulse. The current I is chosen in the interval $Imin \leq I \leq Imax$; where Imin corresponds to the minimum current that needs to be drawn to generate an amplitude of the drop pulse that is distinguishable from voltage fluctuations present in the network segment, and Imax corresponds to the maximum current that can be drawn by the generating device without causing the voltage at the device with the lowest typical voltage ("most critical device") to go below its minimum operating voltage.

For the determination of Imin, a voltage pulse VP with a magnitude that is too low may not be detected by the other devices. In order to be detected, a pulse has to be greater than a minimum value. A typical voltage value Vtyp is defined, for example 1 Volt, above which there is no need to draw extra current if this value is chosen. This has the advantage of limiting the current drawn and thus the consumed power.

The computation of the maximum current that can be drawn to generate the drop pulse may be determined as follows:

$$\text{Imax} = (\Delta Vm\_max / RC) - \Delta ICm \qquad \qquad \textit{[equation 1]}$$

where RC is the cable resistance and $\Delta ICm$ is the current consumption difference between the two voltages $\Delta Vm\_max$ and Vm_op across the device.

Indeed, the current consumption of each device on the segment upon which the pulse is generated changes with the voltage change due to the pulse. The devices have fixed power consumptions, such that if power P is equal to voltage V times current I (P = V * I), then current I is equal to power P divided by voltage V (I = P / V). However, the internal power supply of a device comprises a DC-DC converter 407 (as shown in **Figure 5**), the yield of which is not constant. Therefore, the equation may be approximately a polynomial equation depending on the type of the device according to conventional techniques permitting the value $\Delta ICm$ to be calculated.

For higher reliability of the computation, a factor "n" may be introduced in the equation for determining the maximum current Imax. It may be considered here that available DC to DC converters have essentially the same electrical characteristics, such that:

$$\text{Imax} = (\Delta Vm\_max / RC) - n * \Delta ICm \qquad \qquad \textit{[equation 2]}$$

If for example the maximum number of devices on the segment is four, as currently defined by convention, the value 4 may be substituted for n:

$$\text{Imax} = (\Delta Vm\_max / RC) - 4 * \Delta ICm$$

This current is lower than the actual maximum possible current, thereby preventing the current limitation from being exceeded, such that a power down is prevented or letting the device to enter a non-functional state.

Since the devices are generally unaware of the segment topology, the cable resistance RC may be approximated by the following equation:

$$RC = (Vref - Vm\_typ) * Vm\_typ / PCm\_typ \qquad \qquad \textit{[equation 3]}$$

wherein Vref is a reference voltage across the port 121-n of the PSE 120, and PCm_typ is the typical (unloaded) power consumption of the device 110-m.

The approximated calculated resistance is generally greater than the actual resistance, which is the sum of the other interposed devices (here devices 110-1, 110-2, and 110-3 if device 110-4 is considered), which are consuming power.

One alternative is to adjust the calculated pulse magnitude. As the estimated cable resistance is greater than the actual cable resistance, the calculated current is lower than the maximum current, depending on the consumption of the devices, which is unknown. If the generated voltage drop pulse VP has an insufficient magnitude (total voltage change) to be detected by all devices and the minimum voltage of a device is much less than the minimum operating voltage, a new calculation based on a measured loaded voltage Vm_ld may be done during the voltage pulse. The voltage Vm_ld allows a new cable resistance RC value to be calculated with greater precision, as follows:

$$RC = (Vm\_ld - Vm\_typ) / [(Vm\_typ / P) - (Vm\_ld / P))] \quad \textit{[equation 4]}$$

For a given device (for example device 110-4):

$$RC = (V4\_ld - V4\_typ) / [(V4\_typ / P4) - (V4\_ld / P4))]$$

Then based on the result of the new cable resistor value, a voltage pulse VP with a modified amplitude can be generated.

Above, it has been considered that the segment of cable between the PSE 120 and the first device 110-1 (that is, cable 170-1) has a length of at least 100 meters, which is the maximum length of an Ethernet cable category 5e or 6e. For lengths greater than 100 meters, a coaxial cable with PLC (Power Line Communication) communication means may be used.

A minimum DC resistance thus exists between the PSE 120 and the first device 110-1. A resistance value of about 5 Ω (ohms) for a length of a conventional coaxial cable (such as the conventional cable RG-59/U) still allows a voltage pulse VP to be detected.

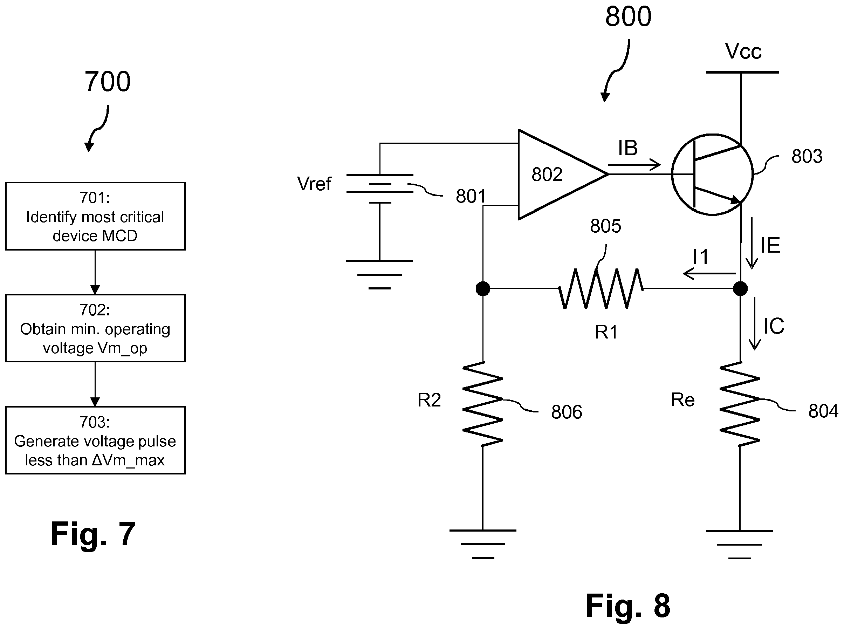

**Figure 7** is a flowchart of a method 700 of determining a magnitude of a voltage pulse to be generated, according to one embodiment of the invention. In particular, a voltage pulse VP is generated. The method 700 comprises steps 701 to 703.

In step 701, the device having the lowest typical voltage Vm_typ, that is to say, the most critical device MCD or node, is identified. Such an identification is performed for example by measuring the voltage across the inputs of different devices and selecting the device with the lowest measured voltage, or else by simulations or estimations taking into account the network topology and characteristics - that is to say, the device that is farthest away from the PSE 120.

In step 702, a threshold representing the minimum operating voltage Vm_op of the most critical device MCD is obtained if known specifically, or else a general minimum operating voltage Vop of the devices otherwise. As previously indicated, the voltage Vm_op may be the same for all devices 110-m, particularly in the case where all the devices are of the same type, such that the voltage Vop is equal to the minimum operating voltage Vm_op of a given device. In another case, the voltage Vm_op may differ between devices, particularly in the case where the devices are of the different types or models, and thus it is preferable that the threshold Vm_op selected is the minimum operating voltage Vm_op of the identified most critical device MCD.

In step 703, a device generates a pulse with the determined magnitude. In one embodiment, it is the most critical device MCD that generates the pulse, the magnitude being less than its maximum voltage range ΔVm_max. The determination of the necessary current to be drawn is thus easier. As the device MCD has the lowest voltage, its determined magnitude is the lowest. Otherwise, there is a risk of dropping below the operating threshold voltage Vm_op, and therefore causing the device MCD to be non-functional.

**Figure 8** shows a circuit diagram of a generating means 800 for generating a voltage pulse VP, according to one embodiment. The generating means 800 may be a current generator integrated in the first sensor 401 of **Figure 5.** According to this embodiment, the generated voltage pulse is a function of the calculated current Imax, given by equation 1 above.

The generating means 800 comprises a voltage reference Vref 801, an operational amplifier 802, a power transistor 803, and resistors 804 (Re), 805 (R1), 806 (R2). The currents IB, IE, IC, and I1 are indicated in the figure. The voltage across the device 110-m is connected between VCC and the ground symbol. The current Imax flows through the transistor 803 and the resistor 804 according to the following equation:

$$\text{Imax} = \text{Vref} * (R1 + R2) / (Re * R2) \qquad \textit{[equation 5]}$$

with IC >> I1 as the resistances R1 and R2 are very high, for example 1000 times, as compared to the resistance Re.

The reference voltage Vref to control the generating means 800 is supplied by a digital to analog converter comprised within the microcontroller 403 of **Figure 5** by means of the switch SW1. The current can thus be tuned to the exact calculated value Imax .

In another embodiment, the generating means comprises an array of power resistors, wherein the calculated current is drawn by switching one or several resistors to obtain the correct current value.

The generation of the pulse may be used to discover devices in the different segments of the communication network as will be explained in further detail below. Generally, as the maximum voltage range of the most critical device has been determined, the generation of a voltage pulse with the same maximum voltage range by any of the devices should not cause any other device to shut down for example.

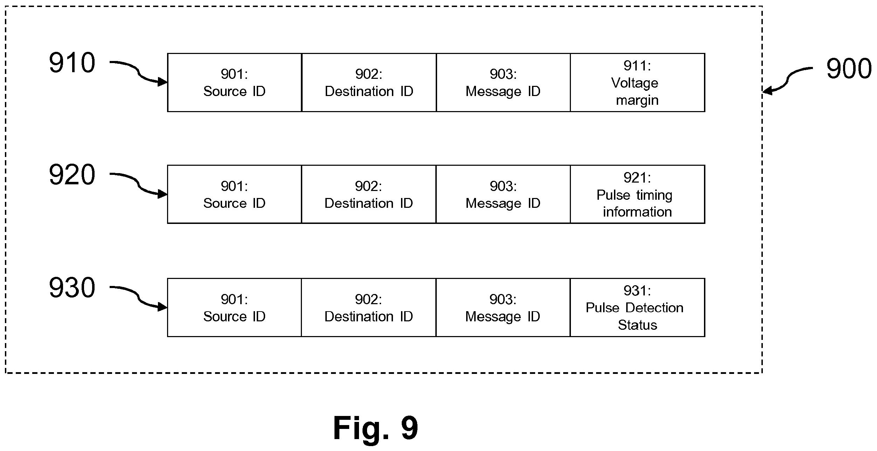

**Figure 9** illustrates a group 900 of messages that may be exchanged within a device, according to an embodiment. In particular, the group 900 of messages comprises messages 910, 920, 930 exchanged between the terminal adapter 300', 300" as described in relation with **Figure 4A** or **4B** and the core camera module 200 of a device 110-m.

In the embodiment shown in **Figure 9**, the messages 910, 920, 930 all comprise a source identification 901, a destination identification 902, and a message identification 903.

The source identification 901 identifies the entity emitting the message, such as the terminal adapter 300', 300" or the core camera module 200.

The destination identifier 902 identifies the entity targeted by the message, such as the core camera module 200 or the terminal adapter 300', 300".

The message identifier 903 uniquely identifies the message.

It may be noted that in various embodiments of the invention, the source ID 901 or destination ID 902 may not be used.

Message 910 is a message used by the core camera module 200 to send a voltage margin VM 911 to its own terminal adapter 300', 300" so that it can generate a pulse according to an embodiment of the invention. The voltage margin 911 is either the maximum voltage range $\Delta Vm\_max = Vm\_typ - Vm\_op$, or the values $Vm\_typ$ and $Vm\_op$, so that the voltage margin may be calculated.

Message 920 is a message used by the core camera module 200 to send a pulse timing information 921 to its own terminal adapter 300', 300" so that it can generate a pulse. The pulse timing information 921 may comprise a time value as to when the pulse is to be generated and/or information relating to the duration of the pulse to be generated.

Message 930 is a message used by the terminal adapter 300', 300" to send a pulse detection result 931 to the core camera module 200, for example a value "1" to indicate "pulse detected" and a value "0" to indicate "no pulse detected".

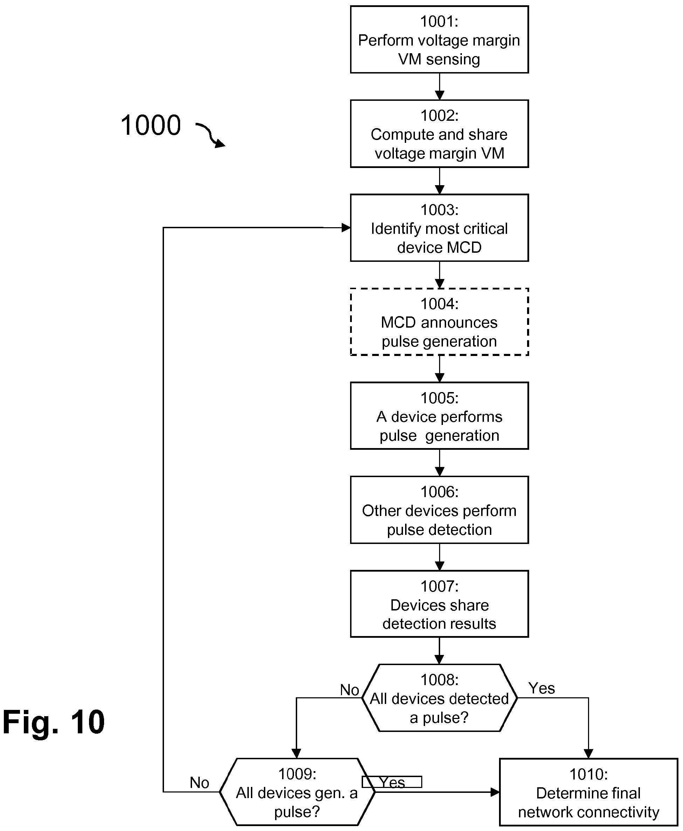

**Figure 10** is a flowchart of a method 1000 of determining network topology by generation of a voltage pulse, according to an embodiment. The method 1000 comprises steps 1001 to 1010.

In step 1001, each device 110-m performs voltage margin VM sensing by measuring the voltage across its inputs. The voltage sensing is performed by any appropriate means known to the skilled person.

In step 1002, each device computes its voltage margin VM as explained above, then shares its voltage margin with the other devices over the data communication network. The computation of each voltage margin may include averaging measured voltage values over a predetermined period of time to obtain a representative value of the voltage across the inputs of the device.

In step 1003, the device having the lowest voltage, the most critical device MCD as indicated in relation with **Figure 7**, is identified by comparing the voltage margins VM for various, and preferably all, devices 110-m. The identification can be performed by a coordinator or "master" device gathering all the results of the voltage margins VM, or by any one or more devices based on the results of the computation. Consequently, the use of a "master device" is not necessary, as the identification can be done by all the devices, with the same final result.

In step 1004 (optional), the most critical device announces a pulse generation on the communication network. The aim of the pulse generation is to discover the devices in the different segments of the communication network 100.

In step 1005, a device, such as the most critical device, performs the pulse generation, wherein the magnitude of the pulse is determined based on its voltage margin VM.

In step 1006, the other devices (that did not generate the pulse in step 1005, thus called non-generating devices) are in a pulse detection mode and thus measure the voltage at their inputs in order to detect, or not, the voltage pulse.

In step 1007, the non-generating devices share their detection results, which are then saved by each device for example in their memory 406 of **Figure 5** in the form of a table as shown below (Table 1), or by a master device only.

In step 1008, it is determined whether all the devices have detected a pulse. If the response is Yes, all the devices have the necessary information in order to deduce the topology of the network, and the method proceeds to step 1010.

Otherwise, if the response is No, the method proceeds to step 1009.

In step 1009, it is determined whether all the devices have generated a pulse. If the response is No, the method then returns to step 1003, and another device performs the pulse generation. For example, the device having the next higher voltage (that is to say, that having the second-to-lowest voltage) of the voltage margins is identified as the most critical device and the method repeats. The magnitude of the voltage drop pulse may be chosen as equal to the maximum (worst case), calculated from its own voltage values, or be determined by any other means.

If the response is Yes, then the method proceeds to step 1010 since any device that did not detect a pulse is alone on its port (segment).

In step 1010, the final network connectivity status is determined, as shown in Table 1 below.

The above method of pulse generation is susceptible to various alternatives.

For example, a device other than the most critical device may announce the pulse generation at step 1004, for example a master device controlling the method. The magnitude of the generated pulse may be set such that the magnitude of the pulse that reaches the most critical device is still above the minimum operational threshold of the most critical device.

In one embodiment, the devices enter the pulse detection mode (step 1006) after reception of the announcement of the pulse generation (step 1004).

In one embodiment, a method of determining the topology of a power network comprises:

- a power source,
- at least one power segment coupled to the power source,

- at least two devices, each device coupled to a power segment and capable of acting as a generating device to generate a physical parameter variation on the power segment to which it is coupled, and capable of acting as a detecting device to detect, on the power segment to which it is coupled, a physical parameter variation generated by a generating device.

The method comprises the steps of:

- detecting for, by a detecting device on the segment to which it is coupled, a physical parameter variation, such as a voltage drop pulse, generated by a generating device;
- causing, by the detecting device, an update of a table storing the topology of the power network, wherein:
- if the physical parameter variation was detected by the detecting device, the table is updated to store an information that the generating device and the detecting device belong to a same power segment, and
- if the physical parameter variation was not detected by the detecting device, the table is updated to store an information that the generating device and the detecting device do not belong to a same power segment.

In one implementation, the following further steps are performed:

- selecting another device that did not detect a previous parameter variation to be a new generating device; and
- generating, by the new generating device, a physical parameter variation on the power segment to which it is coupled.

By detecting or not, by a device, of a physical parameter variation generated on a power segment, the power network topology may be determined. Furthermore, all or a plurality of the devices of the power network may act as generating device, to better ensure that all segments have been identified.

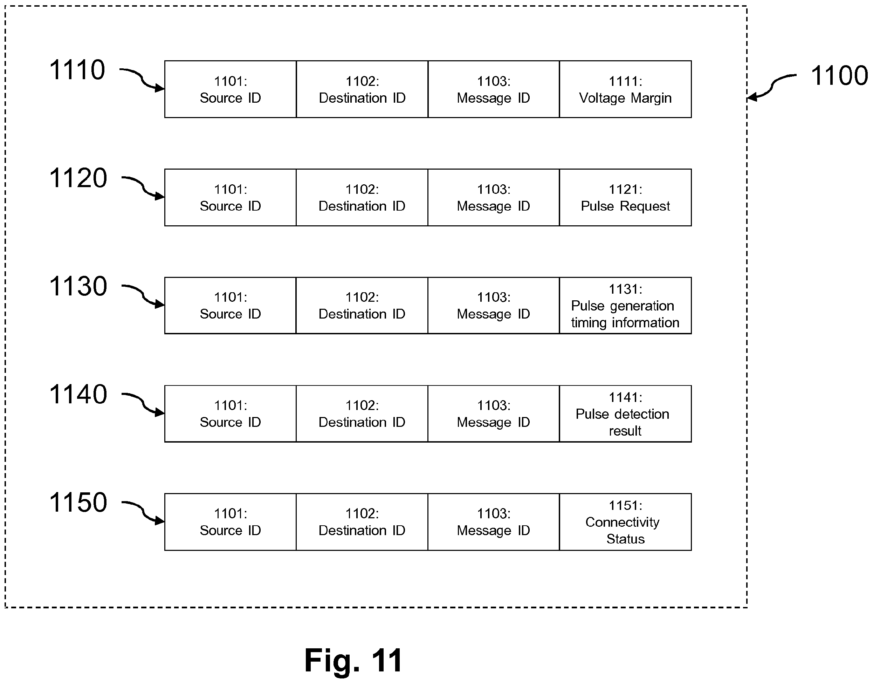

**Figure 11** illustrates a group 1100 of messages that may be exchanged between devices, according to a first embodiment. In particular, the group 1100 of messages comprises messages 1110, 1120, 1130, 1140, 1150 managed for example by the power manager 301 of the terminal adapter or else by the camera module 200.

In this embodiment, the messages 1110, 1120, 1130, 1140, 1150 all comprise a source identification 1101, a destination identification 1102, and a message identification 1103.

The source identification 1101 identifies the entity emitting the message, such as the unique identifier of the device 110-m or an identifier of the camera module 200.

The destination identifier 1102 identifies the entity targeted by the message, such as the unique identifier of the device 110-m or an identifier of the camera module 200.

The message identifier 1103 uniquely identifies the message.

In some embodiments, one or both of the source ID 1101 and the destination ID 1102 may not be used.

Message 1110 is a voltage margin result message used by a device 110-m to send a calculated voltage margin result 1111 to the master device. The voltage margin 1111 is either the maximum voltage range $\Delta Vm\_max = Vm\_typ - Vm\_op$, or the values $Vm\_typ - Vm\_op$, the result $\Delta V$ to be calculated by the master device.

Message 1120 is a pulse generation request message used to send a pulse request 1121 from the master to a device.

Message 1130 is a pulse generation notification message used to notify a pulse generation by a device, the message 1130 comprising timing information 1131 with a time value as to when the pulse will be sent. In one embodiment of the invention, the timing information 1131 may also comprise information relating to the duration of the pulse to be generated. The destination identifier 1102 identifies the device(s) targeted by the message. The message 1130 may be a broadcast message targeting all the devices of the network.

Message 1140 is a pulse detection result message used to send a pulse detection result 1141 from a device to the master device, for example with a value "1" indicating detection and a value "0" indicating a non detection of the pulse.

Message 1150 is a connectivity status result message used to send a connectivity result 1151 to each device after step 1010 of the method 1000 described in relation with **Figure 10.**

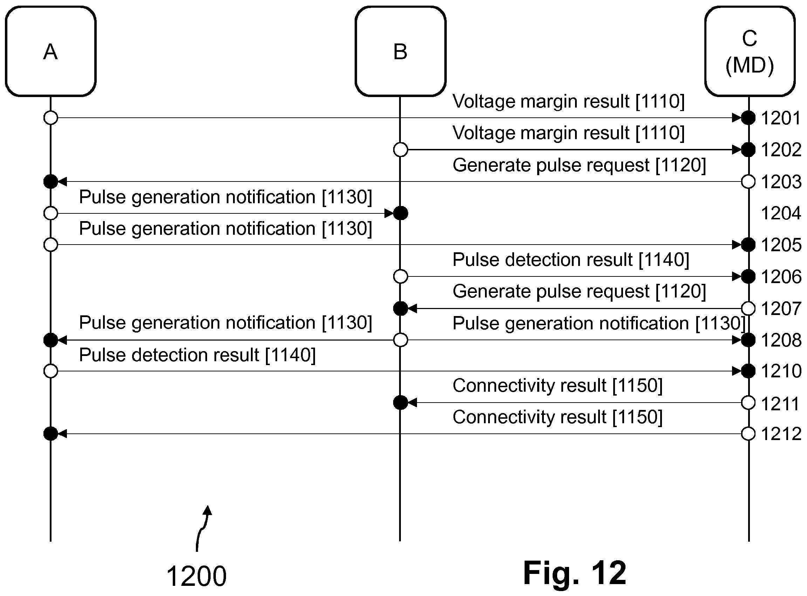

The connectivity result 1151 contains information representative of Table 1 that will be described in further detail in relation with **Figure 12.**

**Figure 12** is a protocol transaction chart 1200 for the exchange of messages amongst devices, according to an embodiment. Three devices, here referenced A, B, C are shown, on the same segment. In this embodiment, a master device MD or coordinator is selected; here device C is selected as the master device (MD). The protocol transaction flow chart comprises message exchanges 1201 to 1212.

In transactions 1201, 1202 the devices A, B respectively send their calculated voltage margins [1110] to the device C. The device C then selects the device (here device A) with the lower voltage margin, as the most critical device.

In transaction 1203, the device C sends a pulse generation request [1120] to the selected device, device A, so that the devices on the same segment may be identified.

In transactions 1204, 1205, the device A sends a pulse generation notification [1130] to the devices B, C respectively (though the order of the sending is irrelevant), and then generates the pulse.

In transaction 1206, the device B sends a pulse detection result [1140] to device C, the master device, so that the connectivity table (Table 1 below) can be completed.

In transaction 1207, the device C sends a pulse generation request [1120] to the next selected device, device B, to continue the identification of devices on the same segment.

In transactions 1208, the device B sends a pulse generation notification [1130] to the devices A, C, and then generates the pulse.

In transaction 1209, the device A sends a pulse detection result [1140] to device C, the master device, so that the connectivity table can be completed.

In transactions 1210, 1211, the device C, the master device, sends a connectivity status result [1150] to the other devices, here to devices A, B respectively, after having determined the connectivity.

In an alternative embodiment, the method 1000 of **Figure 10** and the protocol transaction chart 1200 of **Figure 12** is distributed amongst all the devices of the network, that is to say, all devices receive the pulse detection results (1140) and calculate the connectivity statuses.

Table 1 below represents the connectivity between the devices of the network according to the embodiment shown in **Figure 1.**

The rows R1 to R7 and columns C1 to C7 respectively relate to the references (110-1 to 110-7) of the devices 110-m as shown in **Figure 1**, wherein the rows indicate the devices generating a pulse, and the columns indicate the devices detecting (or not) the pulse.

The diagonals (corresponding to the same device for generating and detection) are indicated as N/A (not applicable) since a same device cannot both generate and detect a pulse at the same time.

As described above, if device 110-4 has the lowest voltage of the segment S1, it is selected first to generate a pulse. The devices 110-1, 110-2, 110-3 detect the pulse, therefore columns C1 to C3 of the row R4 are filled with a "Yes" or "1", indicating that the devices are on the same segment, and the columns C5 to C7 of the row R4 are filled with a "No" or "0", indicating that these devices are not on the same segment.

The other devices generate and detect pulses until Table 1 is completed.

Table 1: Connectivity Table for the system 100

| | C1 (110-1) | C2 (110-2) | C3 (110-3) | C4 (110-4) | C5 (110-5) | C6 (110-6) | C7 (110-7) |
|---|---|---|---|---|---|---|---|
| R1 (110-1) | N/A | Yes | Yes | Yes | No | No | No |
| R2 (110-2) | Yes | N/A | Yes | Yes | No | No | No |
| R3 (110-3) | Yes | Yes | N/A | Yes | No | No | No |
| R4 (110-4) | Yes | Yes | Yes | N/A | No | No | No |
| R5 (110-5) | No | No | No | No | N/A | Yes | No |
| R6 (110-6) | No | No | No | No | Yes | N/A | No |
| R7 (110-7) | No | No | No | No | No | No | N/A |

Though the notification/indication of the detection results (such as the pulse detected or pulse undetected announcements) has been described in the preceding as an exchange of messages on a communication network, it may simply comprise for example changing the state of a flag of the detecting device, from 0 to 1 for example, the flag then being read or communicated by other means.

Although the present invention has been described hereinabove with reference to specific embodiments, the present invention is not limited to the specific embodiments, and modifications which lie within the scope of the present invention will be apparent to a person skilled in the art. In particular different features from different embodiments may be interchanged, where appropriate. Many further modifications and variations will suggest themselves to those versed in the art upon making reference to the foregoing illustrative embodiments, which are given by way of example only and which are not intended to limit the scope of the invention as determined by the appended claims.

**Claims**

1. A method of determining a magnitude of a voltage drop pulse in a network (100) comprising at least two devices (110-m) on a voltage supply line, the method comprising :

measuring typical operating voltages (Vm_typ) of the at least two devices (110-m) in stable operating phases;

determining which of the at least two devices (110-m) has the lowest typical operating voltage as the determined device;

determining a minimum operating voltage (Vm_op) of at least the determined device, below which the determined device will be non-functional; and

determining, from the lowest typical operating voltage, the magnitude of the voltage drop pulse that will not cause the voltage of the determined device to go below the minimum operating voltage;

wherein the determined magnitude is less or equal to a maximum voltage range defined as the difference between the typical voltage of the determined device and the minimum operating voltage, and wherein a security margin is taken into consideration when calculating the determined magnitude.

2. A method of generating a voltage pulse in a network (100) comprising at least two devices (110-m) on a voltage supply line, the method comprising the steps of:

determining the magnitude of the voltage drop pulse according to claim 1; and

generating the voltage drop pulse with the determined magnitude, by the determined device.

3. The method according to claim 2, comprising the steps of:

sending a pulse generation notification by the determined device to a non-generating device or devices before generating the voltage drop pulse; and

receiving the pulse generation notification by the non-generating device or devices; and

measuring by the non-generating device or devices the voltage at their inputs in order to detect or not the generated voltage drop pulse.

4. The method according to claim 2, comprising a step of measuring by the non-generating device or devices the voltage at their inputs in order to detect or not the generated voltage drop pulse.

5. The method according to one of claims 3 or 4, comprising a step of sending a pulse detection result by the non-generating device or devices indicating whether it detected or not the generated voltage drop pulse.

6. The method according to one of claims 2 to 5, comprising the steps of:

determining whether all devices detected a voltage drop pulse;

if the response is no, then determining whether all the devices have generated a voltage drop pulse; and

if the response is no, then generating a voltage drop pulse by another device.

7. A method of determining a network topology, the network (100) comprising at least two devices (110-m) on a voltage supply line, the method comprising the steps of

generating the voltage drop pulse with the determined magnitude by the determined device according to one of claims 2 to 6,

detecting for the voltage drop pulse by the non-generating device or devices,

receiving pulse detection results from the non-generating device or devices, and

determining the network topology based on the pulse detection results.

8. A device to determine the magnitude of a voltage drop pulse in a network (100) comprising at least two devices (110-m) on a same voltage supply line, the device being configured to:

obtain typical operating voltages (Vm_typ) measured by the at least two devices (110-m) in stable operating phases;

determine which of the at least two devices (110-m) has the lowest typical operating voltage as the determined device;

determine a minimum operating voltage (Vm_op) of at least the determined device, below which the determined device will be non-functional; and

determine, from the lowest typical operating voltage, the magnitude of the voltage drop pulse that will not cause the voltage of the determined device to go below the minimum operating voltage;

wherein the determined magnitude is less or equal to a maximum voltage range defined as the difference between the typical voltage of the determined device and the minimum operating voltage, and wherein a security margin is taken into consideration when calculating the determined magnitude.

9. A system comprising a first device according to claim 8 and a second device configured to generate a voltage pulse in a network (100), said network comprising at least one other device on a same voltage supply line as the second device, the second device being configured to:

determine the magnitude of the voltage drop pulse using the first device; and
generate the voltage drop pulse with the determined magnitude.

10. The system according to claim 9, wherein the second device is configured to:

send and receive a pulse generation notification before a voltage drop pulse is generated; and
measure the voltage at its inputs in order to detect or not a generated voltage drop pulse.

11. The system according to claim 10, wherein the second device is configured to measure the voltage at its inputs in order to detect or not a generated voltage drop pulse.

12. The system according to one of claims 10 or 11, wherein the second device is configured to send a pulse detection result indicating whether it detected or not the generated voltage drop pulse.

13. A system according to one of claims 9 to 12, wherein the system further comprises a master device for determining the topology of said network (100) and at least another device configured to detect the voltage drop pulse; and wherein the master device is configured to receive pulse detection results, and to determine the network topology based on the pulse detection results.


**Patentansprüche**

1. Verfahren zum Bestimmen einer Größe eines Spannungsabfallimpulses in einem Netzwerk (100) mit mindestens zwei Vorrichtungen (110-m) auf einer Spannungsversorgungsleitung, wobei das Verfahren aufweist:

Messen von typischen Betriebsspannungen (Vm_typ) der mindestens zwei Vorrichtungen (110-m) in stabilen Betriebsphasen;
Bestimmen, welche der mindestens zwei Vorrichtungen (110-m) die niedrigste typische Betriebsspannung aufweist, als die bestimmte Vorrichtung;
Bestimmen einer minimalen Betriebsspannung (Vm_op) von mindestens der bestimmten Vorrichtung, unter der die bestimmte Vorrichtung nicht funktionsfähig sein wird; und
Bestimmen, aus der der niedrigsten typischen Betriebsspannung, der Größe des Spannungsabfallimpulses, der nicht dazu führt, dass die Spannung der bestimmten Vorrichtung unter die minimale Betriebsspannung sinkt, wobei die bestimmte Größe kleiner oder gleich einem maximalen Spannungsbereich ist, der als die Differenz zwischen der typischen Spannung der bestimmten Vorrichtung und der minimalen Betriebsspannung definiert ist, und wobei eine Sicherheitsspanne bei der Berechnung der bestimmten Größe berücksichtigt wird.

2. Verfahren zum Erzeugen eines Spannungsimpulses in einem Netzwerk (100) mit mindestens zwei Vorrichtungen (110-m) auf einer Spannungsversorgungsleitung, wobei das Verfahren die Schritte aufweist:

Bestimmen der Größe des Spannungsabfallimpulses gemäß Anspruch 1; und
Erzeugen des Spannungsabfallimpulses mit der bestimmten Größe durch die bestimmte Vorrichtung.

3. Verfahren gemäß Anspruch 2, mit den Schritten:

Senden einer Impulserzeugungsbenachrichtigung durch die bestimmte Vorrichtung an eine nicht erzeugende Vorrichtung oder Vorrichtungen, bevor der Spannungsabfallimpuls erzeugt wird; und
Empfangen der Impulserzeugungsbenachrichtigung durch die nicht erzeugende Vorrichtung oder Vorrichtungen; und
Messen, durch die nicht erzeugende Vorrichtung oder Vorrichtungen, der Spannung an deren Eingängen, um den erzeugten Spannungsabfallimpuls zu erfassen oder nicht.

**4.** Verfahren gemäß Anspruch 2, mit einem Schritt des Messens, durch die nicht erzeugende Vorrichtung oder Vorrichtungen, der Spannung an deren Eingängen, um den erzeugten Spannungsabfallimpuls zu erfassen oder nicht.

**5.** Verfahren gemäß einem der Ansprüche 3 oder 4, mit einem Schritt des Sendens eines Impulserfassungsergebnisses durch die nicht erzeugende Vorrichtung oder Vorrichtungen, das angibt, ob diese den erzeugten Spannungsabfallimpuls erfasst hat oder nicht.

**6.** Verfahren gemäß einem der Ansprüche 2 bis 5, mit den Schritten:

Bestimmen, ob alle Vorrichtungen einen Spannungsabfallimpuls erfasst haben;
dann, wenn die Antwort nein ist, Bestimmen, ob alle der Vorrichtungen einen Spannungsabfallimpuls erzeugt haben; und
dann, wenn die Antwort nein ist, Erzeugen eines Spannungsabfallimpuls durch eine andere Vorrichtung.

**7.** Verfahren zum Bestimmen einer Netzwerktopologie, wobei das Netzwerk (100) mindestens zwei Vorrichtungen (110-m) auf einer Spannungsversorgungsleitung aufweist, wobei das Verfahren die Schritte aufweist
Erzeugen des Spannungsabfallimpulses mit der bestimmten Größe durch die bestimmte Vorrichtung gemäß einem der Ansprüche 2 bis 6,
Erfassen des Spannungsabfallimpulses durch die nicht erzeugende Vorrichtung oder Vorrichtungen,
Empfangen von Impulserfassungsergebnissen von der nicht erzeugenden Vorrichtung oder Vorrichtungen, und
Bestimmen der Netzwerktopologie basierend auf den Impulserkennungsergebnissen.

**8.** Vorrichtung zum Bestimmen der Größe eines Spannungsabfallimpulses in einem Netzwerk (100) mit mindestens zwei Vorrichtungen (110-m) auf derselben Spannungsversorgungsleitung, wobei die Vorrichtung konfiguriert ist, um:

typische Betriebsspannungen (Vm_typ) zu erhalten, die von den mindestens zwei Vorrichtungen (110-m) in stabilen Betriebsphasen gemessen werden;
zu bestimmen, welche der mindestens zwei Vorrichtungen (110-m) die niedrigste typische Betriebsspannung aufweist, als die bestimmte Vorrichtung;
eine minimale Betriebsspannung (Vm_op) von mindestens der bestimmten Vorrichtung zu bestimmen, unter der die bestimmte Vorrichtung nicht funktionsfähig sein wird; und
aus der niedrigsten typischen Betriebsspannung die Größe des Spannungsabfallimpulses zu bestimmen, der nicht dazu führt, dass die Spannung des bestimmten Bauteils unter die minimale Betriebsspannung sinkt, wobei die bestimmte Größe kleiner oder gleich einem maximalen Spannungsbereich ist, der als die Differenz zwischen der typischen Spannung der bestimmten Vorrichtung und der minimalen Betriebsspannung definiert ist, und wobei eine Sicherheitsspanne bei der Berechnung der bestimmten Größe berücksichtigt wird.

**9.** System mit einer ersten Vorrichtung gemäß Anspruch 8 und einer zweiten Vorrichtung, die konfiguriert ist, um einen Spannungsimpuls in einem Netzwerk (100) zu erzeugen, wobei das Netzwerk aufweist
mindestens eine andere Vorrichtung auf derselben Spannungsversorgungsleitung wie die zweite Vorrichtung, wobei die zweite Vorrichtung konfiguriert ist, um:

die Größe des Spannungsabfallimpulses unter Verwendung der ersten Vorrichtung zu bestimmen; und
den Spannungsabfallimpuls mit der bestimmten Größe zu erzeugen.

**10.** System gemäß Anspruch 9, wobei die zweite Vorrichtung konfiguriert ist, um:

Impulserzeugungsbenachrichtigungen zu senden und zu empfangen, bevor ein Spannungsabfallimpuls erzeugt wird; und
die Spannung an deren Eingängen zu messen, um einen erzeugten Spannungsabfallimpuls zu erfassen oder nicht.

**11.** System gemäß Anspruch 10, wobei die zweite Vorrichtung konfiguriert ist, um:
die Spannung an deren Eingängen zu messen, um einen erzeugten Spannungsabfallimpuls zu erfassen oder nicht.

**12.** System gemäß einem der Ansprüche 10 oder 11, wobei die zweite Vorrichtung konfiguriert ist, um ein Impulserkennungsergebnis zu senden, das angibt, ob diese den erzeugten Spannungsabfallimpuls erfasst hat oder nicht.

13. System gemäß einem der Ansprüche 9 bis 12, wobei das System weiterhin eine Master-Vorrichtung zum Bestimmen der Topologie des Netzwerks (100) und mindestens eine andere Vorrichtung, die konfiguriert ist, um den Spannungsabfallimpuls zu erfassen, aufweist;
und wobei die Master-Vorrichtung konfiguriert ist, um Impulserfassungsergebnisse zu empfangen, und um die Netzwerktopologie basierend auf den Impulserfassungsergebnissen zu bestimmen.

## Revendications

1. Procédé de détermination d'une amplitude d'une impulsion de chute de tension dans un réseau (100) comprenant au moins deux dispositifs (110-m) sur une ligne d'alimentation en tension, le procédé comprenant les étapes consistant à :

mesurer des tensions de fonctionnement typiques (Vm_typ) des au moins deux dispositifs (110-m) dans des phases de fonctionnement stables ;
déterminer lequel des au moins deux dispositifs (110-m) présente la tension de fonctionnement typique la plus basse en tant que dispositif déterminé ;
déterminer une tension de fonctionnement minimale (Vm_op) d'au moins le dispositif déterminé, en dessous de laquelle le dispositif déterminé sera non opérationnel ; et
déterminer, à partir de la tension de fonctionnement typique la plus basse, l'amplitude de l'impulsion de chute de tension qui n'amènera pas la tension du dispositif déterminé à aller en-dessous de la tension de fonctionnement minimale ;
dans lequel l'amplitude déterminée est inférieure ou égale à une plage de tension maximale définie en tant que différence entre la tension typique du dispositif déterminé et la tension de fonctionnement minimale, et dans lequel une marge de sécurité est prise en considération lors du calcul de l'amplitude déterminée.

2. Procédé de génération d'une impulsion de tension dans un réseau (100) comprenant au moins deux dispositifs (110-m) sur une ligne d'alimentation en tension, le procédé comprenant les étapes de :

détermination de l'amplitude de l'impulsion de chute de tension selon la revendication 1 ; et
génération de l'impulsion de chute de tension avec l'amplitude déterminée, par le dispositif déterminé.

3. Procédé selon la revendication 2, comprenant les étapes de :

envoi d'une notification de génération d'impulsion par le dispositif déterminé à un ou des dispositif(s) non générateur(s) avant de générer l'impulsion de chute de tension ; et
réception de la notification de génération d'impulsion par le ou les dispositif(s) non générateur(s) ; et
mesure par le ou les dispositif(s) non générateur(s) de la tension au niveau de leurs entrées afin de détecter ou non l'impulsion de chute de tension générée.

4. Procédé selon la revendication 2, comprenant une étape de mesure par le ou les dispositif (s) non générateur (s) de la tension au niveau de leurs entrées afin de détecter ou non l'impulsion de chute de tension générée.

5. Procédé selon l'une des revendications 3 ou 4, comprenant une étape d'envoi d'un résultat de détection d'impulsion par le ou les dispositif(s) non générateur(s) indiquant s'il a détecté ou non l'impulsion de chute de tension générée.

6. Procédé selon l'une des revendications 2 à 5, comprenant les étapes consistant à :

déterminer si tous les dispositifs ont détecté une impulsion de chute de tension ;
si la réponse est non, déterminer alors si tous les dispositifs ont généré une impulsion de chute de tension ; et
si la réponse est non, faire alors générer une impulsion de chute de tension par un autre dispositif.

7. Procédé de détermination d'une topologie de réseau, le réseau (100) comprenant au moins deux dispositifs (110-m) sur une ligne d'alimentation en tension, le procédé comprenant les étapes de :

génération de l'impulsion de chute de tension avec l'amplitude déterminée par le dispositif déterminé selon l'une des revendications 2 à 6,
détection pour l'impulsion de chute de tension par le ou les dispositif(s) non générateur(s),

réception des résultats de détection d'impulsion depuis le ou les dispositif(s) non générateur(s), et
détermination de la topologie de réseau sur la base des résultats de détection d'impulsion.

8. Dispositif destiné à déterminer l'amplitude d'une impulsion de chute de tension dans un réseau (100) comprenant au moins deux dispositifs (110-m) sur une même ligne d'alimentation en tension, le dispositif étant configuré pour :

obtenir des tensions de fonctionnement typiques (Vm_typ) mesurées par les au moins deux dispositifs (110-m) dans des phases de fonctionnement stables ;
déterminer lequel des au moins deux dispositifs (110-m) présente la tension de fonctionnement typique la plus basse en tant que dispositif déterminé ;
déterminer une tension de fonctionnement minimale (Vm_op) d'au moins le dispositif déterminé, en dessous de laquelle le dispositif déterminé sera non opérationnel ; et
déterminer, à partir de la tension de fonctionnement typique la plus basse, l'amplitude de l'impulsion de chute de tension qui n'amènera pas la tension du dispositif déterminé à aller en-dessous de la tension de fonctionnement minimale ;
dans lequel l'amplitude déterminée est inférieure ou égale à une plage de tension maximale définie en tant que différence entre la tension typique du dispositif déterminé et la tension de fonctionnement minimale, et dans lequel une marge de sécurité est prise en considération lors du calcul de l'amplitude déterminée.

9. Système comprenant un premier dispositif selon la revendication 8 et un second dispositif configuré pour générer une impulsion de tension dans un réseau (100), ledit réseau comprenant au moins un autre dispositif sur une même ligne d'alimentation en tension en tant que second dispositif, le second dispositif étant configuré pour :

déterminer l'amplitude de l'impulsion de chute de tension à l'aide du premier dispositif ; et
générer l'impulsion de chute de tension avec l'amplitude déterminée.

10. Système selon la revendication 9, dans lequel le second dispositif est configuré pour :

envoyer et recevoir une notification de génération d'impulsion avant qu'une impulsion de chute de tension ne soit générée ; et
mesurer la tension au niveau de ses entrées afin de détecter ou non une impulsion de chute de tension générée.

11. Système selon la revendication 10, dans lequel le second dispositif est configuré pour mesurer la tension au niveau de ses entrées afin de détecter ou non une impulsion de chute de tension générée.

12. Système selon l'une des revendications 10 ou 11, dans lequel le second dispositif est configuré pour envoyer un résultat de détection d'impulsion indiquant s'il a détecté ou non l'impulsion de chute de tension générée.

13. Système selon l'une des revendications 9 à 12, dans lequel le système comprend en outre un dispositif maître pour déterminer la topologie dudit réseau (100) et au moins un autre dispositif configuré pour détecter l'impulsion de chute de tension ;
et dans lequel le dispositif maître est configuré pour recevoir des résultats de détection d'impulsion, et pour déterminer la topologie de réseau sur la base des résultats de détection d'impulsion.

Fig. 1

EP 3 483 700 B1

**Fig. 2**

**Fig. 3**

EP 3 483 700 B1

Fig. 4B

Fig. 4A

Fig. 5

**Fig. 6A**

**Fig. 6B**

EP 3 483 700 B1

EP 3 483 700 B1

700

701:
Identify most critical
device MCD

702:
Obtain min. operating
voltage Vm_op

703:
Generate voltage pulse
less than ΔVm_max

**Fig. 7**

800

**Fig. 8**

**Fig. 9**

1000

**Fig. 10**

```
┌─────────────────────┐
│ 1001:               │
│ Perform voltage     │
│ margin VM sensing   │
└──────────┬──────────┘
           │
           ▼
┌─────────────────────┐
│ 1002:               │
│ Compute and share   │
│ voltage margin VM   │
└──────────┬──────────┘
           │
           ▼
┌─────────────────────┐
│ 1003:               │
│ Identify most       │
│ critical device MCD │
└──────────┬──────────┘
           │
           ▼
┌ ─ ─ ─ ─ ─ ─ ─ ─ ─ ─ ┐
  1004:
│ MCD announces       │
  pulse generation
└ ─ ─ ─ ─ ─┬─ ─ ─ ─ ─ ┘
           │
           ▼
┌─────────────────────┐
│ 1005:               │
│ A device performs   │
│ pulse generation    │
└──────────┬──────────┘
           │
           ▼
┌─────────────────────┐
│ 1006:               │
│ Other devices       │
│ perform pulse       │
│ detection           │
└──────────┬──────────┘
           │
           ▼
┌─────────────────────┐
│ 1007:               │
│ Devices share       │
│ detection results   │
└──────────┬──────────┘
           │
           ▼
        1008:
No  / All devices    \ Yes
   < detected a pulse? >
        1009:
No  / All devices    \ Yes
   <  gen. a pulse?   >
           │
           ▼
┌─────────────────────┐
│ 1010:               │
│ Determine final     │
│ network connectivity│
└─────────────────────┘
```

1100

**1110** →

| 1101: Source ID | 1102: Destination ID | 1103: Message ID | 1111: Voltage Margin |

**1120** →

| 1101: Source ID | 1102: Destination ID | 1103: Message ID | 1121: Pulse Request |

**1130** →

| 1101: Source ID | 1102: Destination ID | 1103: Message ID | 1131: Pulse generation timing information |

**1140** →

| 1101: Source ID | 1102: Destination ID | 1103: Message ID | 1141: Pulse detection result |

**1150** →

| 1101: Source ID | 1102: Destination ID | 1103: Message ID | 1151: Connectivity Status |

## Fig. 11

C
(MD)

B

A

Voltage margin result [1110]
Voltage margin result [1110]
Generate pulse request [1120]
Pulse detection result [1140]
Generate pulse request [1120]
Pulse generation notification [1130]
Connectivity result [1150]
Connectivity result [1150]

Pulse generation notification [1130]
Pulse generation notification [1130]
Pulse generation notification [1130]
Pulse detection result [1140]

1201
1202
1203
1204
1205
1206
1207
1208
1210
1211
1212

1200

**Fig. 12**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008052546 A1